# EUROPEAN PATENT APPLICATION

(11) **EP 4 653 576 A1**
(43) Date of publication of application: **26.11.2025**
(21) Application number: 24000057.0
(22) Date of filing: 22.05.2024
(51) Int. Cl.: C23C 16/00, C23C 16/02, C23C 16/26, C23C 28/04, C23C 14/00, C23C 28/00

(54) **CARBON BASED COATING WITH COLORING LAYER**

(71) Applicant: Oerlikon Surface Solutions AG, Pfäffikon, 8808 Pfäffikon (CH)
(72) Inventor: Herzbach, Daniel, 55262 Heidesheim (DE); Brunner, Markus, 72181 Starzach (DE); Drabik, Martin, 7320 Sargans (CH)

(57) **Abstract**

Carbon based coatings like DLC (Diamond-Like Carbon) coatings are used in diverse industries due to their ability to reduce friction and minimize wear. Carbon based coatings typically have a characteristic anthracite or dark gray color, which in many cases does not fulfil color preferences and design requirements. To combine functional attributes with aesthetic color, a coating layer system is presented, combining one or more coating layer providing functional properties with a coating layer adjusted to provide a color to the coated substrate, in particular through us of interference effects. The coating layer system may have a functional carbon based layer of DLC, a reflective layer of a metal, metal carbide, or metal nitride, and a carbon based top layer. A method to produce a coating layer system using PVD and PECVD techniques is also disclosed.

## Description

The present invention relates to a coating layer system used to provide functional and decorative properties to substrates and a method for producing the coating layer system.

### Technical Field

Carbon based coatings like DLC (Diamond-Like Carbon) coatings are a type of thin film coating applied to various surfaces for enhanced performance and durability. These coatings exhibit properties similar to natural diamond, combining hardness, smoothness, and low friction. DLC coatings are commonly used in diverse industries, including automotive, aerospace, consumer electronic and medical applications.

An overview of DLC coatings are given in the norm VDI 2840, published by the Association of German Engineers in March 2023. According to the norm, DLC coatings can be classified as hydrogen free or hydrogen containing. The hydrogen free DLC types include a-C with predominantly sp2 binding type, ta-C with predominantly sp3 binding type, and a-C:Me with predominantly sp2 binding type modified by a metallic element (Me). The hydrogen containing DLC types include a-C:H which may have mixed sp2 and sp3 binding type, ta-C:H with predominantly sp3 binding type, a-C:H:Me with predominantly sp2 binding type modified by a metallic element (Me), and a-C:H:X with predominantly sp2 binding type modified by a non-metallic element (X). Modifying metallic elements (Me) may include W and Ti. Modifying non-metallic elements (X) may include Si, O, N, F or B.

The coating process for DLC involves depositing a layer of amorphous carbon onto a substrate using various techniques such as physical vapor deposition (PVD), plasma enhanced vapor deposition (PECVD) or chemical vapor deposition (CVD) or a combination of these processes. The result is a surface that possesses hardness values much close to that of diamond, making it resistant to wear, abrasion and corrosion.

One key advantage of DLC coatings is their ability to reduce friction, which can enhance the efficiency of moving components in machinery or engines. This property is particularly beneficial in improving fuel efficiency in automotive applications and minimizing wear in medical devices.

Additionally, DLC coatings provide a protective barrier against chemical and environmental factors, contributing to the longevity of coated surfaces. The applications of DLC coatings range from coating engine components in the automotive industry to enhancing the performance of cutting tools, medical implants, and even consumer electronics.

In the current landscape of decorative coatings, Physical Vapor Deposition (PVD) techniques have gained prominence for their ability to impart unique aesthetic qualities to various surfaces. Common practices involve the deposition of thin metallic layers onto substrates, producing visually appealing colors, finishes, and textures. The state of the art has witnessed the application of PVD coatings in diverse industries, including jewelry, watches, architectural elements, and automotive components. However, challenges persist in optimizing these coatings to simultaneously achieve a broad spectrum of visual effects and ensure durability. The conventional application of DLC (Diamond-Like Carbon) coatings, often prized for their exceptional hardness, low friction coefficient and wear resistance, tends to result in a characteristic anthracite or dark gray color (L*=lightness) that lie in the range above 40. In this case and in the present description, the CIE 1976 L*a*b* color space, which is based on D65 standard lighting and a d/8° (=diffuse lightning, and measurement at under 8°), is taken as a basis.

On the other hand, with nitride or carbon nitride based coatings (e.g. TiN or TiCN) a wider space of colors is possible. It is possible to reach a*-values (green to red) between -10 up to +15 and b*-values (blue to yellow) between -30 up to 45. These coatings also can have a high hardness but a significantly higher friction coefficient compared to DLC coatings.

The color limitation of DLC poses a challenge in meeting the diverse color preferences and design requirements across various industries. As consumer expectations evolve, there is an increasing demand for decorative PVD coatings that not only offer superior functionality but also a broader spectrum of visually appealing colors, beyond the typical darker tones associated with DLC and carbon based coatings.

In the realm of decorative coatings, existing techniques often face limitations in achieving a harmonious balance between aesthetic appeal and functional attributes. Conventional methods for applying Physical Vapor Deposition (PVD) coatings have encountered challenges in simultaneously offering a diverse range of colors, finishes, and textures, while maintaining robust durability, and especially hardness, optimized friction coefficient and improved wear resistance. The prior art has struggled to provide a comprehensive solution that seamlessly integrates both decorative and functional aspects within a single coating process.

### Objective of the invention

An objective of the present invention is therefore to at least partially overcome these challenges and advance the capabilities of functional and decorative coatings. Thereby enhanced functional attributes may be combined with vibrant aesthetics across a myriad of applications.

### Description of the invention

According to a first aspect of the invention, a coated substrate with coating layer system is provided, wherein the coating layer system comprises at least one coating layer providing functional properties and further comprises at least one coating layer adjusted to provide a color to the coated substrate. The color may also be created through a combination of coating layers within the coating layer system.

According to a second aspect of the invention, a method is provided to produce a coating layer system onto a substrate.

The color of the inventive coating layer system may be created by using the effect of interference. The interference effect in thin films refers to the phenomenon where incident light waves undergo constructive or destructive interference upon reflection or transmission through a thin layer. This results in the enhancement or suppression of certain wavelengths, leading to the formation of distinct interference patterns.

According to an embodiment of the first aspect of the invention, the coating layer system may comprise one functional carbon based layer comprising or consisting of at least one material selected from the group consisting of a-C:H, a-C:H:X, ta-C, ta-C:X, a-C and a-C:X, wherein X denotes Si and/or O which may be added as doping elements. The coating layer system may further include a reflective layer which consist of or comprise a metal, a metal carbide, or a metal nitride. In particular, the reflective layer may comprise or consist of at least one of the metals, metal carbides, or metal nitrides selected from the group consisting of Cr, Cr-C, Cr-N Ti, Ti-C, Ag, Zr and Al. The coating layer system may further include a carbon based top layer comprising or consisting of at least one material selected from the group consisting of a-C:H, a-C:H:X, ta-C, ta-C:X, a-C and a-C:X, wherein X denotes Si and/or O which may be added as doping elements.

In a preferred embodiment, the carbon based top layer is the outermost layer of the coating layer system. In other words, the carbon based top layer is the layer of the coating layer system that is the furthest away from the substrate and in contact with the ambient.

In a preferred embodiment, the reflective layer has a reflection of at least 80% of the visible light. Ideally the reflection is close to 100%. The L*- values should have at least 60 up to 100 points, a* and b* values should be close to 0.

In a preferred embodiment, the reflective layer is located between the functional carbon based layer and the carbon based top layer. As such, the reflective layer may be further distant to the substrate compared to the functional carbon based layer and less distant to the substrate compared to the carbon based top layer. In one embodiment, the reflective layer is contiguous to the carbon based top layer.

The thickness of the reflective layer may be in the range from 10 nm to 300 nm, preferably about 50 nm.

The thickness of the carbon based top layer may be tuned depending on the desired color so that the desired color appear utilizing the interference effect. The thickness may as such be low enough that the carbon based top layer is optically transparent or partially transparent. Preferably, the thickness of the carbon based top layer is in the range from 10 nm to 80 nm. In particular, the thickness of the carbon based top layer may be about 60 nm.

In a particular embodiment, the thickness of the carbon based top layer yields a color in the range of a* = -3 to -16, b*= -3 to -20, preferably in the range of a* = -8 to -9, b*= -13 to -14 as characterized according to CIE 1976 L*a*b* color space, in SCI (specular component included) mode.

The thickness of the functional carbon based layer may be in the range from 0.2 µm to 5 µm. The functional carbon based layer may have a hardness of not less than 15 GPa, further preferred is a hardness of not less than 20 GPa. Coatings with doping elements such as Si and/or O may have a hardness of not less than 10 GPa. Sufficiently high hardness of the functional carbon based layer is important for the function of the layer system in terms of wear and friction. From practical and theoretical limitations, the hardness of carbon-based coatings is typically not higher than 70 GPa. For example, ta-C may exhibit hardness in the range from 50 GPa to 60 GPa. The functional carbon based layer thus preferably has a hardness in the range from 15 GPa to 70 GPa, further preferred in the range from 20 GPa to 70 GPa. Hardness of coating layers may be determined through nanoindentation methods, which is well known for a person skilled in the art.

In one embodiment, the functional carbon based layer may comprise hydrogen (H), for example in the form of a-C:H. In particular, the H content may be in the range from 12 wt.% (percentage by weight) to 14 wt.%.

In a further embodiment of the first aspect, the coating layer system may comprise a functional carbon based layer, a reflective layer and a carbon based top layer, which may be according to previously described embodiments, and additionally an adhesion layer to improve bonding to the substrate. The adhesion layer may consist of or comprise a metal, in particular the adhesion layer may comprise or consist of at least one metal selected from the group consisting of Cr, Zr and Ti. The adhesion layer may be located between the substrate and the functional carbon based layer, in other words less distant to the substrate compared to the functional carbon based layer. Preferably the adhesion layer is directly on top of the substrate, in particular contiguous with the substrate.

The adhesion layer may have a thickness in the range from 50 nm to 5 µm, preferably the thickness of the adhesion layer is in the range from 200 nm to 400 nm.

In a further embodiment of the first aspect, the coating layer system may comprise an adhesion layer and a functional carbon based layer, which may be according to previously described embodiments, and additionally comprise an intermediate layer between the adhesion layer and the functional carbon based layer. The intermediate layer may thus be further distant from the substrate compared to the adhesion layer and less distant from the substrate compared to the functional carbon based layer. The intermediate layer may comprise or consist of at least one metal carbide or metal nitrides selected from the group consisting of Cr-C, Cr-N, Ti-N, Ti-C,. In a particular embodiment, the intermediate layer is Cr-C.

In a further embodiment of the first aspect, the coating layer system may comprise a functional carbon based layer and a reflective layer, which may be according to previously described embodiment, and additionally comprise a first transition layer between the functional carbon based layer and the reflective layer. The first transition layer may thus be further distant from the substrate compared to the functional carbon based layer and less distant from the substrate compared to the reflective layer. The first transition layer may comprise C and a metallic element Me1, wherein the concentration of C and/or Me1 may vary along the thickness of the transition layer. Me1 preferably comprise or consist of at least one of the elements selected from the group consisting of Cr, Ti, Ag, and Al. In particular, Me1 may be Cr. In one preferred embodiment, the concentration of Me1 increases over the thickness of the first transition layer in the direction from the functional carbon based layer towards the reflective layer. The concentration of Me1 is thus lower in a segment of the first transition layer which is close to the functional carbon based layer compared to a segment of the first transition layer which is close to the reflective layer. In a particular embodiment, the concentration of Me1 may be increasing gradually over the thickness of the first transition layer, furthermore the concentration profile of Me1 may be characterized by a monotone increase, and in particular a continuous monotone increase.

In one preferred embodiment, the concentration of C decreases over the thickness of the first transition layer in the direction from the functional carbon based layer towards the reflective layer. The concentration of C is thus higher in a segment of the first transition layer which is close to the functional carbon based layer compared to a segment of the first transition layer which is close to the reflective layer. In a particular embodiment, the concentration of C may be decreasing gradually over the thickness of the first transition layer, furthermore the concentration profile of C may be characterized by a monotone decrease, and in particular a continuous monotone decrease.

The first transition layer may have a thickness below 20 nm, in particular the thickness may be in the range from 2 nm to 20 nm. The first transition can advantageously provide improved adhesion.

In a further embodiment of the first aspect, the coating layer system may comprise at least a reflective layer and a carbon based top layer, which may be according to previously described embodiment, and additionally comprise a second transition layer between the reflective layer and the carbon based top layer. The second transition layer may thus be further distant from the substrate compared to the reflective layer and less distant from the substrate compared to the carbon based top layer. The second transition layer may comprise C and a metallic element Me2, wherein the concentration of C and/or Me2 may vary along the thickness of the transition layer. Me2 preferably comprise or consist of at least one of the elements selected from the group consisting of Cr, Ti, Ag, and Al. In particular, Me2 may be Cr. In one preferred embodiment, the concentration of Me2 decreases over the thickness of the second transition layer in the direction from the reflective layer towards the carbon based top layer. The concentration of Me2 is thus higher in a segment of the second transition layer which is close to the reflective layer compared to a segment of the first transition layer which is close to carbon based top layer. In a particular embodiment, the concentration of Me2 may decrease gradually over the thickness of the second transition layer, furthermore the concentration profile of Me2 may be characterized by a monotone decrease, and in particular a continuous monotone decrease.

In one preferred embodiment, the concentration of C increases over the thickness of the second transition layer in the direction from the reflective layer towards the carbon based top layer. The concentration of C is thus lower in a segment of the second transition layer which is close to the reflective layer compared to a segment of the second transition layer which is close to the carbon based top layer. In a particular embodiment, the concentration of C may be increasing gradually over the thickness of the second transition layer, furthermore the concentration profile of C may be characterized by a monotone increase, and in particular a continuous monotone increase.

The second transition layer may have a thickness below 20 nm, in particular the thickness may be in the range from 2 nm to 20 nm. The second transition can advantageously provide improved adhesion.

In a further embodiment of the first aspect, the coating layer system may comprise at least an adhesion layer and a functional carbon based layer, which may be according to previously described embodiment, and additionally comprise a third transition layer between the adhesion layer and the functional carbon based layer. The third transition layer may thus be less distant from the substrate compared to the functional carbon based layer. The third transition layer may comprise C and a metallic element Me3, wherein the concentration of C and/or Me3 may vary along the thickness of the transition layer. Me3 preferably comprise or consist of at least one of the elements selected from the group consisting of Cr, Ti, Ag, and Al. In particular, Me3 may be Cr. In one preferred embodiment, the concentration of Me3 decreases over the thickness of the third transition layer in the direction from the adhesion layer towards the functional carbon based layer. The concentration of Me3 is thus higher in a segment of the third transition layer which is close to the adhesion layer compared to a segment of the first transition layer which is close to the functional carbon based layer. In a particular embodiment, the concentration of Me3 may decrease stepwise or gradually over the thickness of the third transition layer, furthermore the concentration profile of Me3 may be characterized by a monotone decrease, and in particular a continuous monotone decrease.

In one preferred embodiment, the concentration of C increases over the thickness of the third transition layer in the direction from the adhesion layer towards the functional carbon based layer. The concentration of C is thus lower in a segment of the third transition layer which is close to the adhesion layer compared to a segment of the third transition layer which is close to the functional carbon based layer. In a particular embodiment, the concentration of C may be increasing gradually over the thickness of the third transition layer, furthermore the concentration profile of C may be characterized by a monotone increase, and in particular a continuous monotone increase.

The third transition layer may have a thickness in the range from 50 nm to 500 nm. The third transition can advantageously provide improved adhesion.

According to an embodiment of the first aspect of the invention, the coating layer system may comprise a plurality of functional carbon based layers, each comprising or consisting of at least one material selected from the group consisting of a-C:H, a-C:H:X, ta-C, ta-C:X a-C and a-C:X, wherein X denotes Si and/or O which may be added as doping elements. The functional carbon layers may be intervened by interface layers of a metal or a metal carbide. The plurality of functional carbon based layers and interface layers may in particular be arranged in an ... B/A/B/A/B/A/B/A... type layering sequence, wherein "A" denote a functional carbon based layer and "B" denote an interface layer. The number of A/B bilayers can be in the range between 2 and 50, wherein one bilayer include one functional carbon based layer "A" and one interface layer "B". Preferably, the number of A/B bilayers are in the range between 10 and 50, most preferred between 20 and 40. The layering sequence may be started with an interface layer "B", such that the first layer of the layering sequence closest to the substrate is an interface layer "B". An adhesion layer may be provided between the substrate and the first layer of the layering sequence. The coating layer system may further include a reflective layer on top of the layering sequence, thus further distant from the substrate than the layering sequence. The coating layer system may further include carbon based top layer on top of the reflective layer, thus further distant from the substrate than the reflective layer.

In one particular embodiment of the first aspect of the invention, the coating layer system may consist of a reflective layer and a carbon based top layer. In this embodiment, the coating layer system does not have a functional carbon based layer. The coating layer system may thus consist of two layers, in particular of only two layers. This coating design may be advantageous for applications with less demanding functional requirements, where coatings can be produced efficiently and economically with few process steps and shorter coating time. The carbon based top layer may be on top of the reflective layer and so being further distant to the substrate compared to the reflective layer.

In one further particular embodiment of a coating system without a functional carbon based layer, the coating layer system may consist of an adhesion layer, a reflective layer and a carbon based top layer. The coating layer system may thus consist of three layers, in particular of only three layers. This embodiment may as well be advantageous for applications with less demanding functional requirements, where the adhesion layer may provide improved adhesion to the substrate at the slight cost of the introduction of one further process step. The carbon based top layer may be on top of the reflective layer and so being further distant to the substrate compared to the reflective layer.

The inventive coating layer system may be applied to a wide range of substrates of different materials. In particular, substrates may include metals, metallic alloys and steels. In some cases, the substrates may comprise Cr, in which case an adhesion layer of Cr may be well suited.

Features of the described embodiments of the coating layer system may be combined to form new embodiment in as far as not contradictory, as evident to a person skilled in the art.

In an embodiment of the second aspect of the invention, the coating layer system may be deposited onto at least a part of a substrate by using at least one PVD (Physical Vapor Deposition) technique. PVD techniques may include sputtering, magnetron sputtering, high power pulsed magnetron sputtering (HiPIMS), cathodic arc evaporation, and filtered cathodic arc evaporation. It may be provided that more than one PVD technique is used, sequentially or simultaneously.

In an embodiment of the second aspect of the invention, the coating layer system may be deposited onto at least a part of the substrate using a combination of PVD and PECVD (plasma enhanced chemical vapor deposition) methods. A PVD method may preferably be sputtering. The PVD and PECVD methods may be used for producing different coating layers in the coating layer system. The method may such include switching between PVD and PECVD techniques.

Plasma-enhanced chemical vapor deposition (PECVD) is a deposition method where chemical reactions are used in the deposition process which occur after creation of a plasma of the reacting gases.

In particular, PECVD may be used to deposit a functional carbon based layer according to the invention, whereby the PECVD process may be operated while a hydrocarbon gas, preferably C₂H₂, is supplied. During the operation of the PECVD process, a bias voltage may be applied to the substrates. In particular, a negative substrate bias may be used.

PVD may be used to deposit a reflective layer according to the invention. At least one target is operated as source material for the deposition, wherein the target may be a metal target and in particular may comprise or consist of at least one of the metals selected from the group consisting of Cr, Ti, Ag, and Al. The PVD process may be operated under gas flow, where the gas may be a pure reactive gas or a pure non-reactive gases, or may be a mixture of non-reactive gases, a mixture of reactive gases, or a mixture of at least one non-reactive gas with at least one reactive gas. A non-reactive gas may be one selected from the group of Ar, Ne, Kr, and He. A reactive gas may include hydrocarbon gases or nitrogen. In a particular embodiment, a mixture of Ar with a hydrocarbon gas, preferably C₂H₂, is used for the deposition of the reflective layer. During the operation of the PVD process, a bias voltage may be applied to the substrates. In particular, a negative substrate bias may be used.

In an embodiment of the second aspect of the invention, the method comprises a first step where a PECVD technique is used to deposit a functional carbon based layer, followed by a second step where a PVD method is used to deposit a reflective layer. In a preferred embodiment, the second step may be followed by a third step where a PECVD technique is used to deposit a carbon based top layer. In a particular embodiment, the second step follows directly after completion of the first step, and the third step follows directly after completion of the second step.

The first step for deposition of a functional carbon based layer may include providing a constant supply of hydrocarbon gas. In particular, a hydrocarbon gas may be supplied at constant flow rate for the duration of the first step. It may be provided that the hydrocarbon gas is supplied in pure form, in the sense that no other reactive or non-reactive gases are added to the process.

The second step for deposition of the reflective layer may include providing a gas mixture of at least one inert gas and at least one hydrocarbon gas, preferably a mixture of Ar and C₂H₂. In particular, the at least one inert gas and the at least one hydrocarbon gas may be supplied at constant flow rate for the duration of the second step.

In a particular embodiment, the same hydrocarbon gas is provided in the first step and in the second step. The flow rate of the hydrocarbon gas may be higher during the first step compared to the second step.

### Examples

The invention will be explained with reference to examples which are to be understood as exemplary embodiments. The examples are not intended to limit the scope of the invention.

Some of the examples are illustrated by figures. The figures show
Fig. 1 shows a schematic representation of a fist example of a substrate (2) coated with a coating layer system (1).
Fig. 2 shows a schematic representation of a second example, where the coating layer system in addition to the example illustrated in Fig. 1 includes transition layers (7, 8, 9) and an intermediate layer (10).

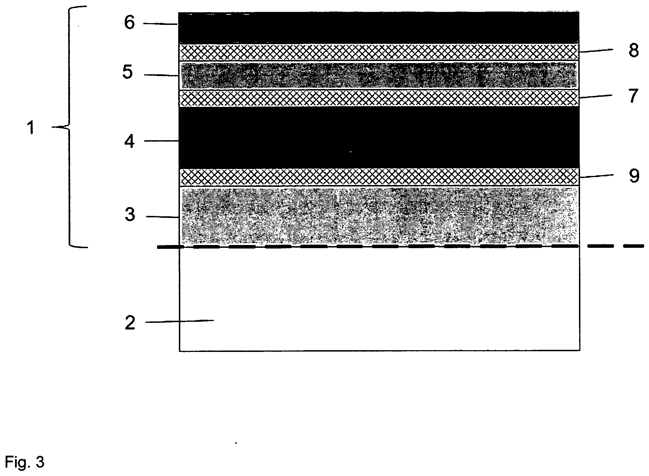

Fig. 3 shows a schematic representation of a third example, where the coating layer system in addition to the example illustrated in Fig. 1 includes transition layers (7, 8, 9) but no intermediate layer.

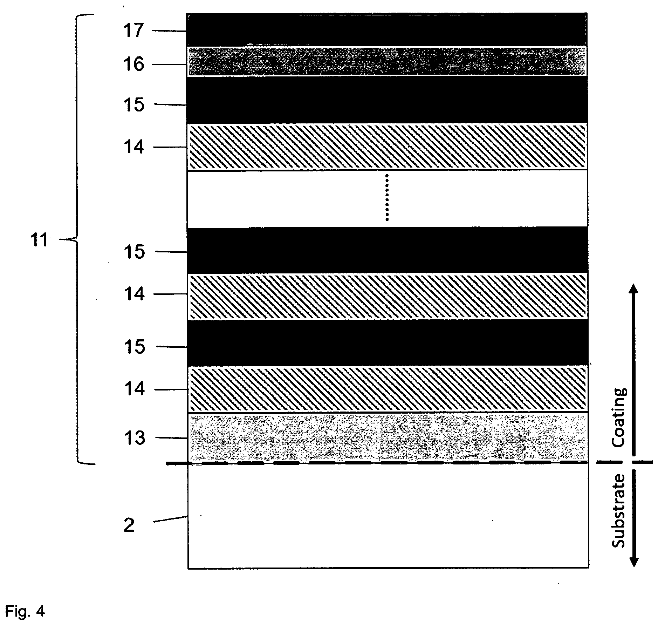

Fig. 4 shows a schematic representation of a fourth example where the coating layer system includes several functional carbon based layers and interface layers.

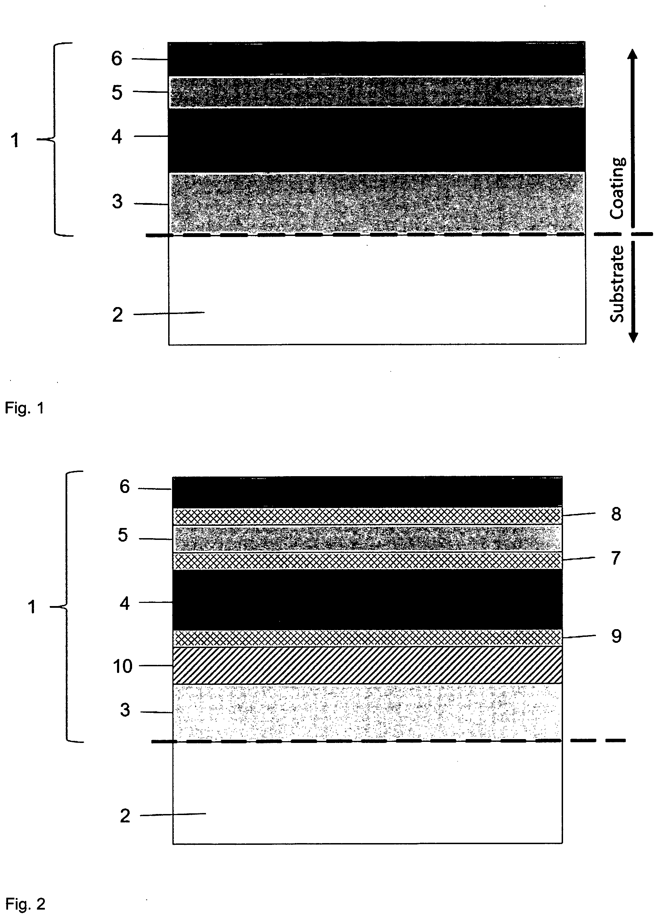

The creation of a coating layer system as illustrated in Fig. 1 is now described in detail. In a first step, an adhesion layer (3) of chrome (Cr) is applied in a PVD process (sputtering) from one Cr-target using argon (Ar) as process gas in a vacuum chamber. In this step a negative substrate bias is turned on at a magnitude of 100 V. The adhesion layer (3) is deposited to a thickness of around 200 - 400 nm, by controlling the deposition time.

In a second step an amorphous carbon layer with a proportion of hydrogen is deposited as functional carbon based layer (4). This layer is applied keeping constant acetylene flow and constant bias, while the Cr target is turned off. The functional carbon based layer (4) is deposited to a thickness of 300 - 500 nm, by controlling the deposition time.

In a third step, Cr-C is deposited as reflective layer (5) by turning on the Cr-target at 12 kW and simultaneously providing 100 sccm acetylene flow and supplying a negative bias of 400 V. This step is continued until the reflective layer has grown to a thickness of 50 nm.

In a fourth step, the reflective carbon based top layer (6) is deposited. In this step, the Cr-target is turned off, the acetylene flow is set to 340 sccm and the a negative substrate bias of 650 V applied. The fourth step is continued until the carbon based top layer has reached a thickness of 60 nm. Due to the thin carbon based top layer in combination with the reflective layer, interference effects occur which create a blueish coloring of the coated substrate.

The creation of a coating layer system as illustrated in Fig. 2 is now described in detail. In a first step, an adhesion layer (3) of chrome (Cr) is applied in a PVD process (sputtering) from one Cr-target using argon (Ar) as process gas in a vacuum chamber. In this step a negative substrate bias is turned on with a magnitude of 100 V. The Cr adhesion layer is deposited to a thickness of around 200 - 400 nm, by controlling the deposition time.

In a second step a layer of chrome carbide is deposited as intermediate layer (10). Therefore, acetylene is admitted to the coating chamber: Acetylene acts as a source for carbon as needed for the carbon proportions of the coating. After deposition of the intermediate layer, a transition layer (9) is created in a third step. In this third step, the flow of acetylene as well as the substrate bias are increased over about 20 minutes. When a certain ratio of chrome and acetylene is reached, the parameters remain constant for a few minutes. The acetylene flow and substrate bias are thereafter further increased, and the power of the chrome sputtering targets is reduced. The sputtering of the Cr-target is subsequently turned off by reducing the sputtering power to 0. The acetylene flow is reduced and the magnitude of the substrate bias is increased to 650 V. When this substrate bias voltage is reached, the deposition parameters remain constant to apply the functional carbon based layer (4) in a fourth process step. The functional carbon based layer is an amorphous carbon layer with a proportion of hydrogen. This layer has a thickness of 300 - 500 nm.

In a fifth step, a transition layer (7) from the functional carbon based layer is created in that the sputtering source with the Cr-target is turned on and the power ramped from 10 to 12 kW. The acetylene flow is simultaneously reduced to 100 sccm and the magnitude of the substrate bias is decreased gradually to 400 V. In a sixth step, a reflective layer (5) of chrome carbide (Cr-C) is deposited by keeping the deposition parameters constant as at the end of the ramps in the fifth step. The sixth step is continued for about 6 minutes. In a 7th step, the sputtering power of the Cr target is reduced from 12 kW to 0 to turn off Cr, creating a transition layer (8). At the same time, the acetylene flow is increased to 340 sccm and the magnitude of the substrate bias increased to 650 V. In an 8th step, the carbon based top layer (6) is deposited by keeping deposition the deposition parameters constant as at the end of the ramps in the 7th step. The 8th steps is continued until the carbon based top layer has reached a thickness of 60 nm. Due to the thin carbon based top layer in combination with the reflective layer, interference effects occur which create a blueish coloring of the coated substrate.

The following table provides further examples of design of the coating layer system. The included layers are numbered starting from the substrate.

| Layer | Example A | Example B | Example C | Example D | Example E | Example F |
|---|---|---|---|---|---|---|
| Ambient | | | | | | |
| 6 | - | - | - | - | - | Carbon based top layer |
| 5 | - | - | Carbon based top layer | - | Carbon based top layer | Reflective layer |
| 4 | - | Carbon based top layer | Reflective layer | Carbon based top layer | Reflective layer | First transition layer |
| 3 | Carbon based top layer | Reflective layer | Functional carbon based layer | Reflective layer | First transition layer | Functional carbon based layer |
| 2 | Reflective layer - | Functional carbon based layer | Intermediate layer | First transition layer | Functional carbon based layer | Intermediate layer |
| 1 | Functional carbon based layer | Adhesion layer | Adhesion layer | Functional carbon based layer | Adhesion layer | Adhesion layer |
| Substrate | | | | | | |

| Layer | Example G | Example H | Example I | Example J | Example K | Example L |
|---|---|---|---|---|---|---|
| Ambient | | | | | | |
| 7 | - | - | - | - | - | Carbon based top layer |
| 6 | - | - | Carbon based top layer | - | Carbon based top layer | Second transition layer |
| 5 | - | Carbon based top layer | Second transition layer | Carbon based top layer | Second transition layer | Reflective layer |
| 4 | Carbon based top layer | Second transition layer | Reflective layer | Second transition layer | Reflective layer | First transition layer |
| 3 | Second transition layer | Reflective layer | Functional carbon based layer | Reflective layer | First transition layer | Functional carbon based layer |
| 2 | Reflective layer | Functional carbon based layer | Intermediate layer | First transition layer | Functional carbon based layer | Intermediate layer |
| 1 | Functional carbon based layer | Adhesion layer | Adhesion layer | Functional carbon based layer | Adhesion layer | Adhesion layer |
| Substrate | | | | | | |

| Layer | Example M | Example N | Example O | Example P | Example Q | Example R |
|---|---|---|---|---|---|---|
| Ambient | | | | | | |
| 7 | - | - | - | Carbon based top layer | - | - |
| 6 | - | Carbon based top layer | Carbon based top layer | Second transition layer | - | - |
| 5 | Carbon based top layer | Reflective layer | Second transition layer | Reflective layer | - | - |
| 4 | Reflective layer | First transition layer | Reflective layer | First transition layer | - | - |
| 3 | Functional carbon based layer | Functional carbon based layer | Functional carbon based layer | Functional carbon based layer | - | Carbon based top layer |
| 2 | Third transition layer | Third transition layer | Third transition layer | Third transition layer | Carbon based top layer | Reflective layer |
| 1 | Adhesion layer | Adhesion layer | Adhesion layer | Adhesion layer | Reflective layer | Adhesion layer |
| Substrate | | | | | | |

### List of Reference Signs

- 1: Coating layer system
- 2: Substrate
- 3: Adhesion layer (optional)
- 4: Functional carbon based layer
- 5: Reflective layer
- 6: Carbon based top layer
- 7: First transition layer
- 8: Second transition layer
- 9: Third transition layer
- 10: Intermediate layer

- 11: Coating layer system
- 12: Substrate
- 13: Adhesion layer (optional)
- 14: Interface layer
- 15: Functional carbon based layer
- 16: Reflective layer
- 17: Carbon based top layer

## Claims

1. Coated substrate with a coating layer system comprising a functional carbon based layer, wherein the functional carbon based layer has a thickness of at least 0.2 µm, and wherein the functional carbon based layer comprises at least one of the materials selected from the list of a-C:H, a-C:H:X, ta-C, ta-C:X a-C and a-C:X, wherein X denotes Si and/or O, **characterized in that**
the coating layer system further comprises
- one reflective layer, and
- a carbon based top layer,
wherein the reflective layer comprise at least one of the metals, metal carbides, or metal nitrides selected from the group consisting of Cr, Cr-C, Cr-N, Ti, Ti-C, Ag, Zr and Al, wherein the carbon based top layer comprises at least one of the materials selected from the group of a-C:H, a-C:H:X, ta-C, ta-C:X a-C and a-C:X,
wherein the carbon based top layer is the outermost layer of the coating layer system.

2. Coated substrate with a coating layer system according to claim 1, wherein the thickness of the carbon based top layer is in the range from 10 nm to 80 nm, preferably 60 nm.

3. Coated substrate with a coating layer system according to claim 1 or 2, wherein the reflective layer has a thickness in the range from 10 nm to 300 nm, preferably 50 nm

4. Coated substrate with a coating layer system according to any of the preceding claims, wherein the color values according to the CEI system is in the range of
a* = -3 to -16, and
b*= -3 to -20

5. Coated substrate with a coating layer system according to any of the preceding claims, wherein the reflective layer consist of Cr-C.

6. Coated substrate with a coating layer system according to any of the preceding claims, wherein the coating layer system further comprises an adhesion layer between the substrate and the functional carbon based layer, wherein the adhesion layer comprises at least one metal selected from the group of Cr, Zr and Ti.

7. Coated substrate with a coating layer system according to any of the preceding claims, wherein the coating layer system further comprises a first transition layer between the functional carbon based layer and the reflective layer, wherein the first transition layer comprises C and a metallic element Me1, wherein the metallic element Me1 is selected from the group of Cr, Ti, Ag, and Al.

8. Coated substrate with a coating layer system according to claim 7, wherein the concentration of Me1 increases over the thickness of the first transition layer in the direction from the functional carbon based layer towards the reflective layer, preferably the concentration profile is a gradual increase, in particular a monotone increase.

9. Coated substrate with a coating layer system according to claim 7 or 8, wherein the concentration of C decreases over the thickness of the first transition layer in the direction from the functional carbon based layer towards the reflective layer, preferably the concentration profile is a gradual decrease, in particular a monotone decrease.

10. Coated substrate with a coating layer system according to any of the preceding claims, wherein in that the carbon based top layer is contiguous with the reflective layer.

11. Coated substrate with a coating layer system according to any of the preceding claims, wherein the coating layer system further comprises an intermediate layer between the substrate and the functional carbon based layer, or if the coating layer system comprises an adhesion layer, between the adhesion layer and the functional carbon based layer, wherein the intermediate layer comprises at least one material selected from the list of Cr-C, Cr-N, Ti-N, and Ti-C, preferably the intermediate layer consist of Cr-C.

12. Coated substrate with a coating layer system according to claim 1, wherein the coating layer system comprises a plurality of functional carbon based layers intervened by interface layers of a metal or a metal carbide, wherein functional carbon based layers and interface layers are arranged in an ... B/A/B/A/B/A/B/A... type layering sequence, wherein "A" denote a functional carbon based layer and "B" denote an interface layer, wherein the number of A/B bilayers is in the range from 2 to 50, preferrable in the range from 20 to 40.

13. Coated substrate with a coating layer system according to claim 13, wherein the interface layers consist of Cr-C.

14. Method to produce a coating layer system wherein a combination of PVD and PECVD is used **characterized in that**
the coating layer system comprises a functional carbon based layer, one reflective layer, and a carbon based top layer,
wherein the functional carbon based layer comprises at least one of the materials selected from the list of a-C:H, a-C:H:X, ta-C, ta-C:X a-C and a-C:X, wherein X denotes Si and/or O
wherein the reflective layer comprise at least one of the metals, metal carbides, or metal nitrides selected from the group consisting of Cr, Cr-C, Cr-N, Ti, Ti-C, Ag, Zr and Al, wherein the carbon based top layer comprises at least one of the materials a-C:H, a-C:H:X, ta-C, ta-C:X a-C and a-C:X,
wherein PVD is used for depositing the reflective layer and PECVD is used for depositing the functional carbon based layer and the carbon based top layer.

15. Method according to claim 14,
wherein the PECVD method is used in a first process step to create the functional carbon based layer, and wherein the PVD is used in a second process step to create the reflective layer, and wherein the PECVD method is used in a third process step to create the carbon based top layer,
wherein the second process step follows directly after completion of the first process step, and the third process step follows directly after completion of the second process step.
